Europäisches Patentamt

European Patent Office

Office européen des brevets

(11) Publication number: **0 196 170**
**B1**

(12) **EUROPEAN PATENT SPECIFICATION**

(45) Date of publication of patent specification: **07.06.89**

(51) Int. Cl.⁴: **C 30 B 25/14,** C 30 B 25/16, C 30 B 31/16, C 23 C 16/44

(21) Application number: **86301535.0**

(22) Date of filing: **05.03.86**

(54) Organic metallic compound pyrolysis vapor growth apparatus.

(30) Priority: **26.03.85 JP 61472/85**

(43) Date of publication of application:
**01.10.86 Bulletin 86/40**

(45) Publication of the grant of the patent:
**07.06.89 Bulletin 89/23**

(84) Designated Contracting States:
**DE FR GB**

(56) References cited:
**US-A-4 393 013**

**JOURNAL OF CRYSTAL GROWTH, vol. 73, no. 1, October 1985, pages 37-42, Elsevier Science Publishers B.V., NL; C.F. SCHAUS et al.: "Optimized growth of grin-sch quantum well lasers by low pressure organometallic vapor phase epitaxy"**

(73) Proprietor: **KABUSHIKI KAISHA TOSHIBA 72, Horikawa-cho Saiwai-ku Kawasaki-shi Kanagawa-ken 210 (JP)**

(72) Inventor: **Ohba, Yasuo c/o Patent Division Kabushiki Kaisha Toshiba 1-1 Shibaura 1-chome Minato-ku Tokyo 105 (JP)**
Inventor: **Yamamoto, Motoyuki c/o Patent Division Kabushiki Kaisha Toshiba 1-1 Shibaura 1-chome Minato-ku Tokyo 105 (JP)**
Inventor: **Muto, Yuhei c/o Patent Division Kabushiki Kaisha Toshiba 1-1 Shibaura 1-chome Minato-ku Tokyo 105 (JP)**

(74) Representative: **Freed, Arthur Woolf et al MARKS & CLERK 57-60 Lincoln's Inn Fields London WC2A 3LS (GB)**

EP 0 196 170 B1

## Description

This invention relates to an organic metallic compound pyrolysis vapor growth apparatus, and more particularly to a vapor growth apparatus adapted for the vapor growth of a crystal consisting of mixed semiconductor compounds.

There are needs for a superhigh speed operation element and visible light semiconductor laser which will have increasing importance in the future highly information-oriented community. These devices need to comprise an epitaxial semiconductor crystal with a precise composition and idealistic hetero interface. Consequently, an organic metallic compound pyrolysis vapor growth method with excellent composition and thickness control would seem most hopeful for the growth of the aforementioned type of semiconductor material. However, the conventional crystal growth apparatus is simply obtained by modifying an apparatus for growing, for example, GaAs, into a device adapted for the vapor growth of a mixed crystal consisting of semiconductor compounds. Consequently, this conventional apparatus does not make the best use of the excellent performance of the organic metallic compound pyrolysis method.

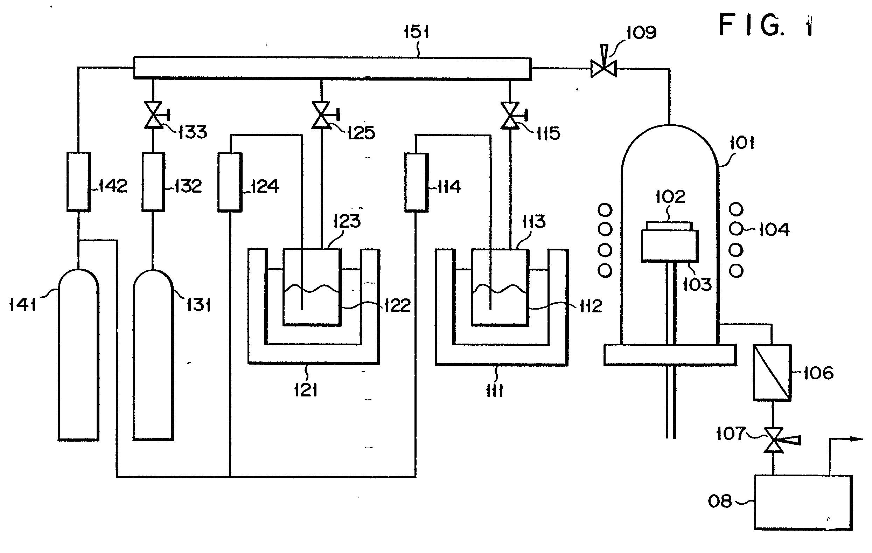

The following describes the drawback of the conventional crystal growth apparatus with reference to Fig. 1 which shows the arrangement of said apparatus. It is designed for the vapor growth of a GaAlAs mixed crystal at an atmospheric pressure or a lower level thereof.

A hydrogen carrier gas is blown into organic metallic compound sources 112 and 122 respectively received in metal containers 113, 123 through the corresponding flow rate controllers, 114 and 124. As a result, vapors are drawn into feed gas manifold 151 from organic metallic compound sources 112 and 122 through the corresponding valves, 115 and 125. Metal containers 113 and 123 are maintained at a prescribed temperature by means of the corresponding temperature controllers, 111 and 121. Arsine gas is drawn from container 131 into feed gas manifold 151 through valve 132 at a controlled flow rate. Hydrogen gas is also conducted from container 141 into feed gas manifold 151 through flow rate controller 142.

The feed gas is supplied into growth chamber 101 through throttle valve 109 from feed gas manifold 151. in this case, the organic metallic compound gases contained in the feed gas in growth chamber 101 are thermally decomposed on a substrate heated by high frequency induction coil 104, which surrounds growth chamber 101, thereby growing a mixed crystal on the substrate. The feed gas in growth chamber 101 is drawn out by exhaust pump 108 through valve 107, which controls the pressure in growth chamber 101.

Crystal growth starts and stops with the opening and closing of valves 115 and 125. The growth speed and composition of the mixed crystal are controlled by flow rate controllers 114 and 124. The pressure in growth chamber 101 is determined by the flow rate of the feed gas introduced into growth chamber 101 and the setting of valve 107. The pressure in feed gas manifold 151 is controlled by throttle valve 109.

The afore-mentioned conventional vapor growth apparatus has certain drawbacks. For example, the operation of valves 115 and 125 for starting and stopping growth of a mixed crystal and the operation of flow rate controllers 114 and 124 for adjusting the composition of the mixed crystal naturally vary the flow rate of feed gas to growth chamber 101. This results in turbulence in growth chamber 101 and heterogeneous composition of the feed gas, and consequently tends to cause a deviation layer the composition of which deviated on the hetero interface of the mixed crystal. When the vapor growth of a mixed crystal is carried out under reduced pressure, the aforementioned difficulties become particularly noticeable; namely, changes in the flow rate of the feed gas to growth chamber 101 cause the pressure in growth chamber 101 and the pressure in metal containers 113 and 123 to vary at the same time, resulting in an unstable flow rate of raw gases to growth chamber 101.

For these reasons, therefore, the mixed crystal vapor growth apparatus in common use to data presented difficulties in achieving vapor growth of a compound semiconductor mixed crystal with a practically perfect hetero interface and a precisely controlled composition. Therefore, there has been a great need to improve the conventional apparatus.

It is, accordingly, the object of this invention to produce an organic metallic compound pyrolysis vapor growth apparatus which can always fix the pressure prevailing in the growth chamber and the flow rate of feed gas running through said growth chamber and can ensure steady production of an epitaxial growth crystal having a satisfactory hetero interface and a precisely controlled composition.

To meet the aforementioned objective, this invention consists of an organic metallic compound pyrolysis vapor growth apparatus which comprises:

a growh chamber containing a substrate on which a single crystal is to be grown and having an inlet and an outlet;

a feed gas supply section connected to the inlet of said growth chamber;

a vent section open to the atmosphere;

a carrier gas source connected to said feed gas supply section and vent section by means of a branched conduit, said feed gas supply section being connected to said vent section by means of said branched conduit;

a raw gas source interchangeably connected to said feed gas supply section and vent section; and

change-over means for selectively conducting the raw gas delivered from said raw gas source to either said feed gas supply section or said vent section as necessary.

The organic metallic compound pyrolysis vapor growth apparatus embodying this invention can keep the pressure in the feed gas supply section at a fixed level, and ensure the consistency of the flow rate of the feed gas to the growth chamber. It also maintains pressure in the growth chamber, the raw gas source, and the growth chamber. Thus, it is possible to ensure the epitaxial growth of a crystal possessing a satisfactory hetero interface and precisely controlled composition.

This invention can be more fully understood from the following detailed description when taken in conjunction with the accompanying drawings, in which:

Fig. 1 is a block diagram illustrating the conventional organic metallic compound pyrolysis vapor growth apparatus; and

Fig. 2 is a block diagram of an organic metallic compound pyrolysis vapor growth apparatus according to a first embodiment of this invention:

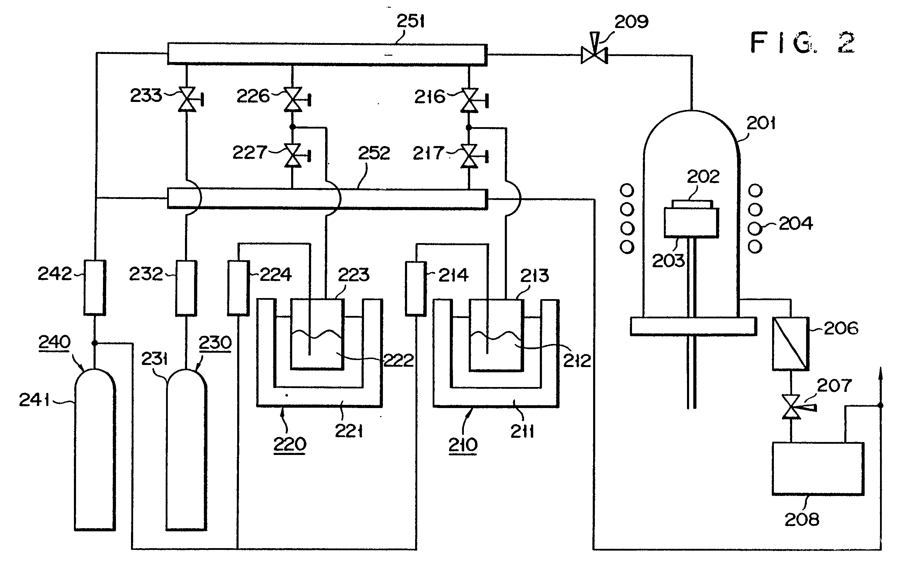

The following is a description of Fig. 2 of an organic metallic compound pyrolysis vapor growth apparatus according to the preferred embodiment.

Fig. 2 is a block diagram of a crystal growth apparatus according to a first embodiment of this invention. This apparatus is intended to effect the vapor growth of GaAlAs under a reduced pressure.

The subject crystal growth apparatus fundamentally comprises:

growth chamber 201 containing crystalline substrate 202;

three raw gas sources (first raw gas source 210, second raw gas source 220 and third raw gas source 230);

carrier gas source 240;

feed gas manifold 251;

vent manifold 252; and

changeover valves 216, 217, 226, 227 for effecting the selective introduction of raw gases into feed gas manifold 251 or vent manifold 252.

In the aforementioned embodiment, the aluminum source consists of trimethyl aluminum (TMA). The gallium source is formed of trimethyl gallium (TMG). The arsenic source is composed of arsine gas ($AsH_3$).

Metal containers 213 and 223 kept at a prescribed temperature by corresponding temperature control devices 211 and 221, respectively, hold organic metallic compounds 212 and 222. A hydrogen carrier gas delivered from cylinder 241 at a controlled flow rate is blown into said organic metallic compounds 212 and 222. As a result, the raw gases saturated with organic metallic vapors are delivered from metal containers 212 and 222 to feed gas manifold 251 or vent manifold 252 through valve 216 or 217 and valve 226 or 227. In this case, organic metallic compound 212 is prepared from TMA, and organic metallic compound 222 is formed of TMG. The arsine ($AsH_3$) acting as an arsenic source is carried through valve 233 into feed gas manifold 251 with the flow rate controlled by flow rate controller 232.

Hydrogen gas is delivered from cylinder 241 to the upstream end of feed gas manifold 251 and the upstream end of vent manifold 252 through the corresponding branched pipes, which have the flow rate kept at a prescribed level by flow rate controller 242. In this case, the flow rate of the hydrogen gas is kept at a higher level than that of the feed gas supplied to growth chamber 201. The downstream end of vent manifold 252 is open to the atmosphere. The downstream end of feed gas manifold 251 is connected to growth chamber 201 through throttle valve 209. The raw gas carried from feed gas manifold 251 through said throttle valve 209 to growth chamber 201 is thermally decomposed on heated crystalline substrate 202, depositing thereon a mixed crystal of GaAlAs. In this case, the unreacted gas is drawn off by exhaust pump 208 through filter 206 and throttle valve 207.

The organic metallic compound pyrolysis vapor growth apparatus of this invention arranged as described above was operated in the following manner. First, flow rate controller 242 set the flow rate at a higher level (5 l/min) than that of the gas entering growth chamber 201. Next, the operation of throttle valves 207 and 209 was regulated to let gas be supplied to growth chamber 201 at a prescribed flow rate (2.5 l/min) and a prescribed pressure (76 torr ($10^4$ Pa)). The arsine gas whose flow rate was regulated to 500 $cm^3$/min by flow rate controller 232 was supplied to feed gas manifold 251. Thereafter, crystalline substrate 202 lying on a carbon susceptor 203 was heated to 750°C by high frequency inductive coil 204. At this time, valves 216 and 226 were closed and valves 217 and 227 were opened causing the TMA gas and TMG gas previously diluted by hydrogen to be supplied into vent gas manifold 252. After 60 minutes passed, flow rate controllers 214 and 224 were set at flow rates of 10 $cm^3$/min and 5 $cm^3$/min. With valves 217 and 227 closed and valves 216 and 226 opened, the TMA gas and TMG gas previously diluted by hydrogen gas were supplied to feed gas manifold 251, thereby starting the growth of a crystal on crystalline substrate 202. The termination of the crystal growth was done by reversing the aforementioned steps.

Throughout the aforementioned crystal-growing process, as vent gas manifold 252 is opened to the atmosphere through a pipe having a small flow resistance, it is always maintained at an atmosphere pressure. As feed gas manifold 251 is connected to the vent manifold 252, it is always held at an atmospheric pressure. The flow rate of gases supplied to growth chamber 201 and the pressure therein are kept constant when opening and closing valves 216, 217, 226 and 227, as well as during the operation of flow rate controllers 214 and 224 to control the flow rate of the TMA gas and TMG gas. Thus, even when the pressure in the various sections of the apparatus tends to be unstable, such as when the crystal vapor growth is started or stopped, the flow rate of gases released from vent manifold 252 to the atmosphere remains unchanged, thereby further raising the stabilities of pressure and gas flow rate in the various components of the subject apparatus. In other words, the present invention improves the stabilities of the pressure and gas flow rate in various sections of the subject apparatus, thus ensuring a stable feed gas supply to the crystal vapor growth chamber. This improves the crystallinity of the mixed crystal produced and ensure the easy and accurate control of the composition and thickness of the mixed crystal grown. Generally, in the vapor growth of GaAlAs mixed crystal by the organic metallic compound pyrolysis method, and atomic ratio of Al to Ga and the speed of the growth of said mixed crystal are determined by the feed amount per unit time organic metallic compounds to growth chamber 201 which is proportionate to the product of the mass flow rate of hydrogen carrier gas blown into containers 213 and 223 by the pressure in containers 213 and 223. Since, with the present invention, the pressure in the containers 213 and 223 is kept constant, the feed amount per unit time of organic metallic compound to growth chamber 201 is perfectly proportionate to the mass flow rate of hydrogen carrier gas blown into containers 213 and 223. Consequently, it is possible to ensure the easy and precise control of the composition of a mixed crystal and the speed of crystal growth.

With the conventional apparatus, however, the flow condition in the growth chamber and quantities of raw gases introduced into the growth chamber do not remain constant when the growth of a mixed crsytal starts and stops nor when the flow rates of raw gases are adjusted, and thus has a tendency toward the occurrence of a deviation layer in the grown layer. In contrast, the present invention offers an advantage in ensuring the epitaxial growth of a mixed crystal having an ideal hetero interface and a precisely controlled composition even under the aforementioned cases.

It is to be noted that this invention is not limited to the foregoing embodiment. The embodiment of Fig. 2 refers to the case where the growth chamber pressure was lower than the surrounding atmosphere. If, however, the gas exhaust section of the subject apparatus is opened to the atmosphere by means of the pressure regulator, the invention can also be used to grow a mixed crystal at higher pressures than the surrounding atmosphere. Further, if in the embodiment of Fig. 2, a carrier gas is drawn into the vent section at a higher pressure than that of the atmosphere, the invention is also applicable to cases where a mixed crystal is grown at a pressure equal or higher than that of the atmosphere. The application of the invention is also not limited to the growth of a mixed crystal of GaAlAs. Obviously, the invention is also applicable to the growth of any other kind of compound semiconductor crystal. Further, the invention can be used in the growth of, for example, Si.

## Claims

1. An organic metallic compound pyrolysis vapor growth apparatus comprising:
   a growth chamber (201) containing a substrate (202) on which a single crystal is to be formed and having an inlet and outlet;
   a feed gas supply section (251) connected to the inlet of said growth chamber;
   a vent section (252) open to the atmosphere;
   a carrier gas source (240) connected to the feed gas supply section (251) and vent section (252) by means of a branched conduit, said feed gas supply section (240) being connected to the vent section (252) by means of said branched conduit;
   a raw gas source (210, 220) interchangeably connected to the feed gas supply section (251) and vent section (251); and
   change-over means (216, 217, 226, 227) for selectively conducting a raw gas from said raw gas source (210, 220) to either said feed gas supply section (251) or said vent section (252).

2. The apparatus according to claim 1, characterized in that said feed gas supply section (251) is connected to the inlet of said growth chamber (201) by means of a throttle valve (209).

3. The apparatus according to claim 1, characterized in that the outlet of said growth chamber (201) is connected to the exhaust means (208) through a throttle valve (207).

4. The apparatus according to claim 1, characterized in that said change-over means consists of valves (216, 217, 226, 227) respectively interposed between said raw gas source (210, 220) and feed gas supply section (251) as well as between said raw gas source (210, 220) and vent section (252).

5. The apparatus according to claim 1, characterized in that said raw gas source (210, 220) comprises a container (213, 223) holding an organic metallic compound and a temperature controller (211, 221) for controlling a temperature within said container (213, 223).

6. The apparatus according to claim 5, characterized in that said carrier gas source (240) is connected to said container (213, 223).

7. The apparatus according to claim 1, characterized in that said growth chamber (201) is surrounded by a high frequency inductive coil (204).

## Patentansprüche

1. Vorrichtung für Gasphasenabscheidung durch Pyrolyse von organischen Metallverbindungen, umfassend
   eine Aufwachs- oder Abscheidungskammer (201), die ein Substrat (202), auf dem ein Einkristall erzeugt werden soll, enthält und einen Einlaß sowie einen Auslaß aufweist, einen an den Einlaß der Abscheidungskammer angeschlossenen Speisegaszufuhrteil (251),
   einen zur Atmosphäre (hin) offenen Belüftungsteil (252), eine mittels einer verzweigten Leitung mit Speisegaszufuhrteil (251) und Belüftungsteil (252) verbundene Trägergasquelle (240), die über die verzweigte Leitung mit dem Belüftungsteil (252) verbunden ist,
   eine wechselbar mit Speisegaszufuhrteil (251) und Belüftungsteil (252) verbindbare Rohgasquelle (210, 220) und
   eine Umschalteinrichtung (216, 217, 226, 227) zum selektiven Zuführen eines Rohgases von der

# EP 0 196 170 B1

Rohgasquelle (210, 220) entweder zum Speisegaszufuhrteil (251) oder zum Belüftungsteil (252).

2. Vorrichtung nach Anspruch 1, dadurch gekennzeichnet, daß der Speisegaszufuhrteil (251) mit dem Einlaß der Abscheidungskammer (201) über ein Drosselventil (209) verbunden ist.

3. Vorrichtung nach Anspruch 1, dadurch gekennzeichnet, daß der Auslaß der Abscheidungskammer (201) mit der (einer) Auslaß- oder Absaugeinheit (208) über ein Drosselventil (207) verbunden ist.

4. Vorrichtung nach Anspruch 1, dadurch gekennzeichnet, daß die Umschalteinrichtung aus Ventilen (216, 217, 226, 227) besteht, die jeweils zwischen die Rohgasquelle (210, 220) und den Speisegaszufuhrteil (251) sowie zwischen die Rohgasquelle (210, 220) und den Belüftungsteil (252) eingeschaltet sind.

5. Vorrichtung nach Anspruch 1, dadurch gekennzeichnet, daß die Rohgasquelle (210, 220) einen eine organische Metallverbindung enthaltenden Behälter (213, 223) und einen Temperaturregler (211, 221) zum Regeln einer Temperatur im Behälter (213, 223) aufweist.

6. Vorrichtung nach Anspruch 1, dadurch gekennzeichnet, daß die Trägergasquelle (240) mit dem Behälter (213, 223) verbunden ist.

7. Vorrichtung nach Anspruch 1, dadurch gekennzeichnet, daß die Abscheidungskammer (201) von einer Hochfrequenz-Induktionsspule (204) umschlossen ist.

**Revendications**

1. Appareil de croissance en phase vapeur par pyrolyse de composés métalliques organiques, comprenant:

une chambre de croissance (201) contenant un substrat (202) sur lequel un monocristal doit être formé et ayant une entrée et une sortie,

une section (251) d'alimentation en gaz d'alimentation, reliée à l'entrée de la chambre de croissance,

une section évent (252) débouchant à l'atmosphère,

une source (240) d'un véhicule gazeux, reliée à la section (251) d'alimentation en gaz d'alimentation et à la section évent (252) par un conduit de dérivation, la section (240) d'alimentation en gaz d'alimentation étant reliée à la section évent (252) par le conduit de dérivation,

une source (210, 220) de matière première gazeuse, connectée de manière interchangeable à la section (251) d'alimentation en gaz d'alimentation et à la section évent (252), et

un dispositif de commutation (216, 217, 226, 227) destiné à conduire sélectivement une matière première gazeuse provenant de la source (210, 220) soit à la section (251) d'alimentation en gaz d'alimentation soit à la section évent (252), selon le cas.

2. Appareil selon la revendication 1, caractérisé en ce que la section (251) d'alimentation en gaz d'alimentation est reliée à l'entrée de la chambre de croissance (201) par l'intermédiaire d'une soupape d'étranglement (209).

3. Appareil selon la revendication 1, caractérisé en ce que la sortie de la chambre de croissance (201) est connectée au dispositif d'échappement (208) par l'intermédiaire d'une soupape d'étranglement (207).

4. Appareil selon la revendication 1, caractérisé en ce que le dispositif de commutation comporte des robinets (216, 217, 226, 227) disposés respectivement entre la source (210, 220) de matière première gazeuse et la section (251) d'alimentation en gaz d'alimentation ainsi qu'entre la source (210, 220) de matière première gazeuse et la section d'alimentation (252).

5. Appareil selon la revendication 1, caractérisé en ce que la source (210, 220) de matière première gazeuse comporte un récipient (213, 223) contenant un composé métallique organique et un organe de réglage de température (211, 221) destiné à régler la température dans le récipient (213, 223).

6. Appareil selon la revendication 5, caractérisé en ce que la source du véhicule gazeux (240) est reliée au récipient (213, 223).

7. Appareil selon la revendication 1, caractérisé en ce que la chambre de croissance (201) est entourée par un enroulement (204) de chauffage par induction à haute fréquence.

5

F I G. 1

FIG. 2